# EUROPEAN PATENT APPLICATION

(11) **EP 3 441 181 A1**
(43) Date of publication of application: **13.02.2019**
(21) Application number: 18187797.8
(22) Date of filing: 07.08.2018
(51) Int. Cl.: B23P 6/00, F01D 5/00, B23K 26/342, B33Y 10/00, B23K 101/00

(54) **METHODS FOR TREATING COMPONENTS FORMED FROM EQUIAXED MATERIAL OR DIRECTIONALLY SOLIDIFIED STRUCTURE, AND TREATED COMPONENTS**

(30) Priority: 09.08.2017 IN 201741028260
(71) Applicant: General Electric Company, Schenectady, NY 12345 (US)
(72) Inventor: SRINIVASAN, Dheepa, 560066 Bangalore, Karnataka (IN); PAL, Joydeep, 560066 Bangalore, Karnataka (IN)
(74) Representative: Foster, Christopher Michael

(57) **Abstract**

Methods for treating components (100) formed from equiaxed material(s) or directionally solidified structures and treated components are disclosed. The method may include machining a portion (104) of the component (100), and direct metal laser depositing (DMLD) a material (124) on the machined portion (104) of the component (100) to form a deposited, directionally solidified structure (106) integral with the component (100). The deposited, directionally solidified structure (106) may include columnar dendrites. Additionally, the treated component (100) may include a body (102) including a machined portion (104). The machined portion (104) of the body (102) may be formed substantially from an equiaxed material or a preexisting directionally solidified structure. The body (102) of the component (100) may also include a deposited, directionally solidified structure (106) formed directly on the machined portion (104) of the body (102). The deposited, directionally solidified structure (106) may be direct metal laser deposited on the machined portion (104) of the body (102).

## Description

### TECHNICAL FIELD

The disclosure relates generally to component treatment processes, and more particularly, to methods for treating components formed from equiaxed material(s), or directionally solidified structures, and treated components formed substantially from equiaxed material(s) or directionally solidified structures.

### BACKGROUND OF THE INVENTION

Gas turbine systems are one example of turbomachines widely utilized in fields such as power generation. A conventional gas turbine system includes a compressor section, a combustor section, and a turbine section. During operation of a gas turbine system, various components in the system, such as turbine blades and stator vanes including airfoils, are subjected to high temperature flows. High temperature flows generally result in increased performance, efficiency, and power output of a gas turbine system. However, subjecting turbine blades and stator vanes to high temperature flows increases the risk of damage to the components over time. Damage to the turbine blades and stator vanes due to exposure to the high temperature flows can include, for example, corrosion, oxidation, thermal fatigue, erosion damage, and material deformation; the latter also known as "material creep." If the turbine blades and/or stator vanes become damaged, the operational life expectancy and/or operational efficiency of the blades and/or vanes, as well as the overall gas turbine system, are negatively affected.

Conventional processes for treating or repairing damaged turbine blades and stator vanes typically include welding pre-fabricated, replacement parts or components, also known as "coupons," to damaged areas. Because the turbine blades and stator vanes are typically manufactured from a single forging or are cast as a single component, the introduction and/or welding of a coupon onto the turbine blades and stator vanes typically affects the properties and/or performance of the repaired component dramatically. That is, while the welded coupon may provide a temporary fix and/or operational improvement for the repaired turbine blades and stator vanes, the efficiency may never be identical to the efficiency before the damage occurred in the repaired turbine blades and stator vanes. Additionally, repairing turbine blades and stator vanes with coupons may require multiple repairs and/or coupons may be need to be replaced multiple times over the operational life of the turbine blades and stator vanes. This situation may be caused by improper, inadequate, and/or inferior welds formed between the turbine blades and stator vanes and the coupon. Improper, inadequate, and/or inferior welds may be a result of, for example, the material of the turbine blades and stator vanes and/or the coupon not being easily welded together and/or the material(s) not lending themselves to strong weld formation between components.

### BRIEF DESCRIPTION OF THE INVENTION

A first aspect of the disclosure provide a method of treating a component, the method including: machining a portion of the component, the component formed from one of an equiaxed material or a preexisting directionally solidified structure; and direct metal laser depositing (DMLD) a material on the machined portion of the component to form a deposited, directionally solidified structure integral with the component.

A second aspect of the disclosure provides a component, including: a body including a machined portion, the machined portion of the body formed substantially from one of an equiaxed material or a preexisting directionally solidified structure; and a deposited, directionally solidified structure formed directly on the machined portion of the body, the deposited, directionally solidified structure laser deposited on the machined portion of the body.

A third aspect of the disclosure provide a method of treating a turbine component, the method including: machining a portion an airfoil of the turbine component, the turbine component formed from one of an equiaxed material or a preexisting directionally solidified structure; and direct metal laser depositing (DMLD) a material on the machined portion of the airfoil of the turbine component to form a deposited, directionally solidified structure integral with the airfoil, the deposited, directionally solidified structure including columnar dendrites.

The illustrative aspects of the present disclosure are designed to solve the problems herein described and/or other problems not discussed.

### BRIEF DESCRIPTION OF THE DRAWINGS

These and other features of this disclosure will be more readily understood from the following detailed description of the various aspects of the disclosure taken in conjunction with the accompanying drawings that depict various embodiments of the disclosure, in which:
FIG. 1 shows a perspective view of an illustrative component formed substantially from equiaxed material and including a directionally solidified structure, according to embodiments of the disclosure. FIG. 1 also includes an insert showing a magnified portion of the directionally solidified structure including columnar dendrites, according to embodiments.
FIG. 2 shows a flow chart of an example process for treating a turbine component for a gas turbine system, according to embodiments of the disclosure.
FIG. 3 shows a perspective view of an illustrative component formed from equiaxed material and including a defect, according to embodiments of the disclosure.
FIG. 4 shows a perspective view of the component of FIG. 3 including a machined portion, according to embodiments of the disclosure.
FIG. 5 shows a perspective view of the component of FIG. 4 including a portion of a directionally solidified structure formed on the machined portion, according to embodiments of the disclosure.
FIG. 6 shows a front view of a portion of the component of FIG. 4 and an illustrative portion of an additive manufacturing system configured to form the directionally solidified structure of FIG. 5, according to embodiments of the disclosure.
FIG. 7 shows a perspective view of the component of FIG. 4 including a directionally solidified structure formed on the machined portion, according to embodiments of the disclosure.
FIG. 8 shows a perspective view of an illustrative component formed from equiaxed material and including an opening defect, according to embodiments of the disclosure.
FIG. 9 shows a perspective view of the component of FIG. 8 including a bored aperture, according to embodiments of the disclosure.
FIG. 10 shows a perspective view of the component of FIG. 8 including a directionally solidified structure formed in the bored aperture, according to embodiments of the disclosure.
FIG. 11 shows a perspective view of a turbine blade formed substantially from equiaxed material and including a directionally solidified structure, according to embodiments of the disclosure.
FIG. 12 shows a perspective view of a stator nozzle formed substantially from equiaxed material and including a directionally solidified structure, according to embodiments of the disclosure.

It is noted that the drawings of the disclosure are not to scale. The drawings are intended to depict only typical aspects of the disclosure, and therefore should not be considered as limiting the scope of the disclosure. In the drawings, like numbering represents like elements between the drawings.

### DETAILED DESCRIPTION OF THE INVENTION

As an initial matter, in order to clearly describe the current disclosure it will become necessary to select certain terminology when referring to and describing relevant machine components within the scope of this disclosure. When doing this, if possible, common industry terminology will be used and employed in a manner consistent with its accepted meaning. Unless otherwise stated, such terminology should be given a broad interpretation consistent with the context of the present application and the scope of the appended claims. Those of ordinary skill in the art will appreciate that often a particular component may be referred to using several different or overlapping terms. What may be described herein as being a single part may include and be referenced in another context as consisting of multiple components. Alternatively, what may be described herein as including multiple components may be referred to elsewhere as a single part.

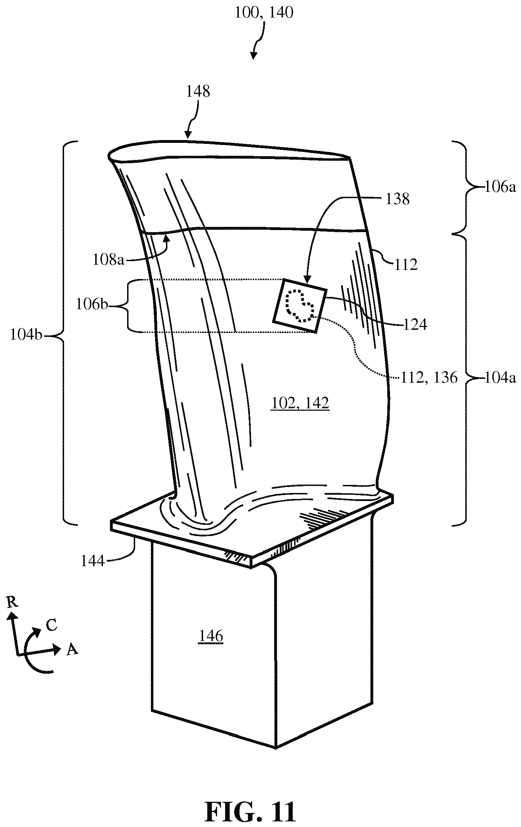

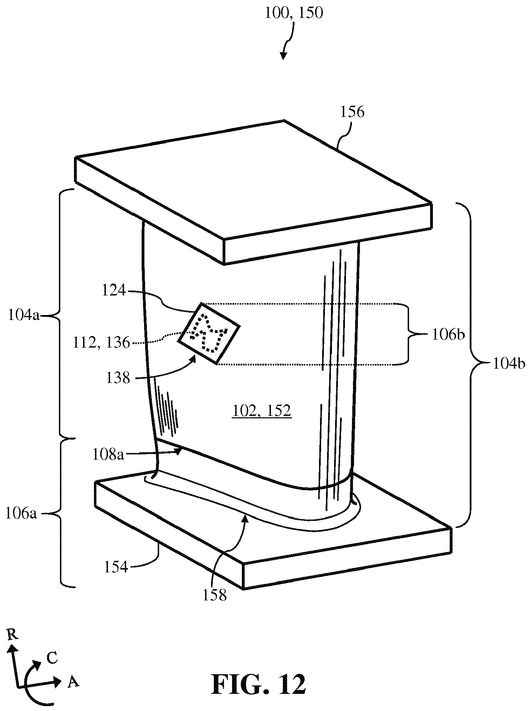

In addition, several descriptive terms may be used regularly herein, and it should prove helpful to define these terms at the onset of this section. These terms and their definitions, unless stated otherwise, are as follows. As used herein, "downstream" and "upstream" are terms that indicate a direction relative to the flow of a fluid, such as the working fluid through the turbine engine or, for example, the flow of air through the combustor or coolant through one of the turbine's component systems. The term "downstream" corresponds to the direction of flow of the fluid, and the term "upstream" refers to the direction opposite to the flow. The terms "forward" and "aft," without any further specificity, refer to directions, with "forward" referring to the front or compressor end of the engine, and "aft" referring to the rearward or turbine end of the engine. Additionally, the terms "leading" and "trailing" may be used and/or understood as being similar in description as the terms "forward" and "aft," respectively. It is often required to describe parts that are at differing radial, axial and/or circumferential positions. The "A" axis represents an axial orientation. As used herein, the terms "axial" and/or "axially" refer to the relative position/direction of objects along axis A, which is substantially parallel with the axis of rotation of the turbine system (in particular, the rotor). As further used herein, the terms "radial" and/or "radially" refer to the relative position/direction of objects along an axis "R" (*see*, FIGs. 11 and 12), which is substantially perpendicular with axis A and intersects axis A at only one location. Finally, the term "circumferential" refers to movement or position around axis A (e.g., direction "C").

The following disclosure relates generally to component treatment processes, and more particularly, to methods for treating components formed from equiaxed material(s), or directionally solidified structures, and treated components formed substantially from equiaxed material(s) or directionally solidified structures

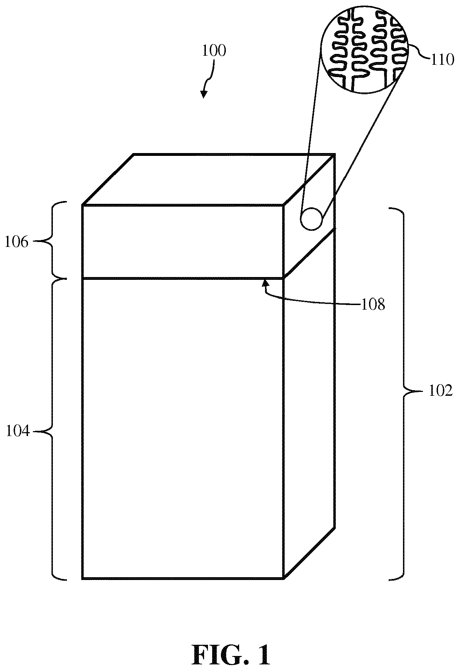

These and other embodiments are discussed below with reference to FIGs. 1 - 12. However, those skilled in the art will readily appreciate that the detailed description given herein with respect to these Figures is for explanatory purposes only and should not be construed as limiting.

FIG. 1 shows a perspective view of an illustrative component 100. More specifically, component 100 of FIG. 1 may be shown or depicted after having undergone a treatment or repair process, as discussed herein. In a non-limiting example, component 100 depicted in FIG. 1 may be a "treated" or "repaired" component 100. However, in another non-limiting example, component 100 shown in FIG. 1 may be formed, created, built and/or manufactured to include the features discussed herein. Additionally, component 100 may be a generic representation of various components that may be formed from substantially similar material, may include similar features, and/or may undergo similar repair processes, as discussed herein. In other non-limiting examples, component 100 may represent components, parts and/or portions of components (*see*, FIGs. 11 and 12) that may be utilized in, for example, turbomachines. Furthermore, it is understood that the terms "treated," treatment," and "treating" may be substantially similar in definition and/or used interchangeably with the terms "repair," and "repairing."

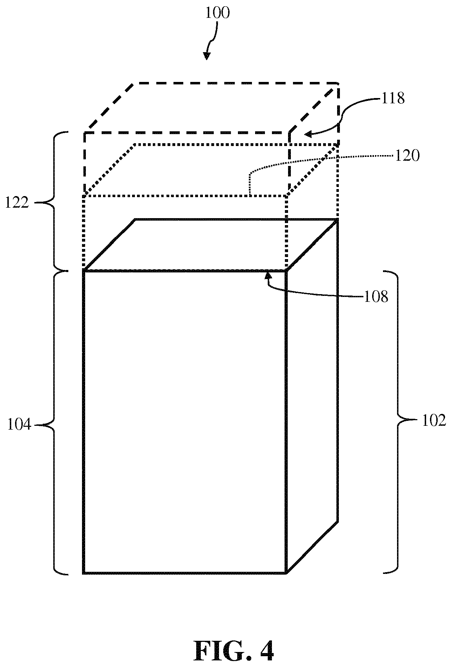

Component 100 may include body 102 including various portions. More specifically, body 102 of component 100 may include and/or be formed from various portions, structures, and/or sections that may be formed from distinct materials and/or may be formed using distinct manufacturing techniques and/or processes. As shown in FIG. 1, body 102 of component 100 may include and/or be formed from machined portion 104 and a deposited, directionally solidified structure 106 (hereafter, "DS structure 106"), respectively. In the non-limiting example, machined portion 104 may be positioned below DS structure 106. As discussed herein, the position of machined portion 104 and DS structure 106 within body 102 may be dependent, at least in part, on the position of a defect identified within body 102 of component 100. Machined portion 104 of component 100 may include a machined surface 108. Machined surface 108 may be formed in machined portion 104 when forming, treating, and/or repairing component 100. That is, and as discussed herein, machined surface 108 of machined portion 104 may be formed when a portion or section of component 100 is removed from body 102 (*see*, FIG. 4).

In a non-limiting example, machined portion 104 of component 100 may be formed from equiaxed material that may include (equiaxed) grains or crystals that include substantially similar or identical sizes, geometries and/or axes lengths. In a non-limiting example, machined portion 104 of component 100 may be formed from equiaxed, nickel-based superalloy material. The nickel-based superalloys forming machined portion 104 may include, but are not limited to, GTD-111, IN738LC, Rene 108, MM247LC, GTD222, GTD444, and other nickel-based superalloys having substantially similar physical and/or chemical properties and characteristics. Machined portion 104 of component 100 may be formed from equiaxed material using any suitable manufacturing technique and/or process including, but not limited to, milling, grinding, lapping, casting, and the like. As discussed herein, component 100 may be originally formed entirely out of equiaxed material prior to undergoing treatment and/or repair processes.

In another non-limiting example, machined portion 104 of component 100 may be formed from a preexisting, directionally solidified structure, that may be distinct from DS structure 106 of component 100. In the non-limiting example, and similar to DS structure 106 discussed herein, the preexisting, directionally solidified structure forming machined portion 104 may include directional or columnar dendrites, or tree-like grain or crystal growth structures that are formed as a result of the grain or crystals growing along favorable crystallographic directions within the material during the directional solidification process. Machined portion 104 of component 100 formed as a preexisting, directionally solidified structure may be formed from nickel-based super alloys including, but not limited to, GTD-111, R108, MM247LC and other nickel-based superalloys having substantially similar physical and/or chemical properties and characteristics. As discussed herein, component 100 may be originally formed entirely out of a preexisting directionally solidified structure prior to undergoing treatment and/or repair processes

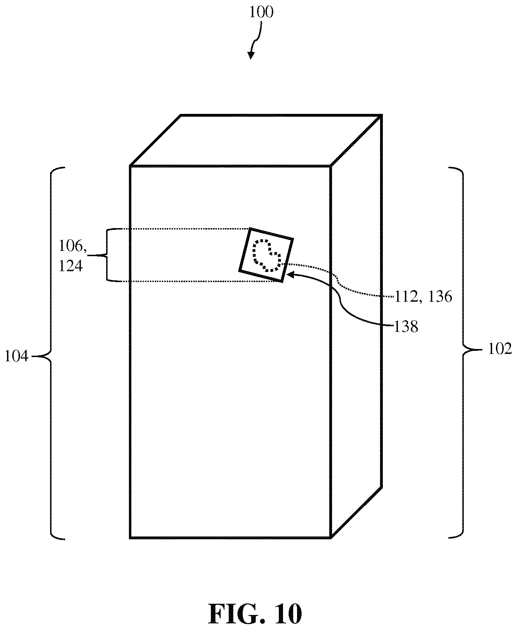

As shown in FIG. 1, DS structure 106 may be formed directly on and/or as a portion of component 100. More specifically, DS structure 106 may be formed directly on and/or integral with machined portion 106 of body 102 of component 100. Additionally, DS structure 106 may be formed directly on machined surface 108 of machined portion 104, such that machined surface 108 of machined portion 104 may be in direct contact with DS structure 106. In the non-limiting example shown in FIG. 1, DS structure 106 may be formed directly on and/or integral with machined portion 104 to substantially form an end of body 102 of component 100. In other non-limiting examples discussed herein (*see*, FIG. 10), DS structure 106 may be formed directly on and/or integral with machined portion 104 to substantially form a central and/or internal portion of body 102 of component 100. Additionally, and as discussed herein, DS structure 106 may include a geometry substantially similar to an initial and/or desired geometry of a section of body 102 removed from component 100 to form machined surface 108. DS structure 106 of component 100 may be formed from nickel-based super alloys including, but not limited to, GTD-111, R108, MM247LC and other nickel-based superalloys having substantially similar physical and/or chemical properties and characteristics.

As discussed herein, DS structure 106 may be formed on and/or integral with machined portion 104 of component 100 by direct metal laser depositing the nickel-based superalloy material directly on machined surface 108 and/or machined portion 104. By direct metal laser depositing the nickel-based superalloy material directly on machined portion 104, the superalloy material forming DS structure 106 may undergo a directional solidification process. As a result of the directional solidification process, DS structure 106 may include directional or columnar dendrites (*see*, FIG. 1, magnified insert 110), or tree-like grain or crystal growth structures that are formed as a result of the grain or crystals growing along favorable crystallographic directions within the material during the directional solidification process. Forming DS structure 106 to include columnar dendrites may improve operational characteristics (e.g., reduce creep, reduce oxidation) for component 100, as discussed herein.

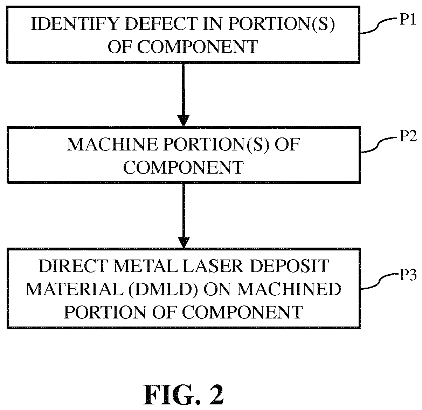

FIG. 2 shows non-limiting example processes for treating and/or repairing a component. Specifically, FIG. 2 is a flowchart depicting example processes for repairing a component formed from an equiaxed material or a preexisting, directionally solidified structure. In some cases, the processes may be used to repair or form component 100, as discussed herein with respect to FIGs. 1 and 3-10. In other non-limiting examples, the processes may be used to repair or form components of turbomachines including turbine blades, as discussed herein with respect to FIG. 11, and/or stator vanes, as discussed herein with respect to FIG. 12.

In process P1, a defect in the component may be identified. More specifically, a defect may be identified, detected, and/or discovered in portion(s) of the body of the component. In a non-limiting example where the component includes a turbine blade or stator vane, and the body includes an airfoil, identifying the defect may include identifying, detecting, and/or discovering the defect in a portion of the airfoil of the turbine blade or stator vane. The defect may include any material, physical, and/or structural anomaly, irregularity, and/or abnormality of the component. For example, the identified defect may include a crack, opening, bend, and/or growth/deformation (e.g., material creep) of the component. The component, and more specifically the body of the component including the identified defect, may be formed from a single, equiaxed material or a preexisting, directionally solidified structure.

In process P2, portion(s) of the component may be machined. Specifically, the portion of the body of the component including the identified defect may be machined. Machining the portion of the component including the identified defect may include eliminating the defect, and/or eliminating the portion including the defect from the component. For example, machining the portion of the component may include removing a section of the component, and more specifically a section of the body of the component, which may include the portion having the identified defect. Removing the section of the turbine component may result in the formation of a machined portion of the component and a machined surface on the component. That is, the remaining portion of the body of the component not removed with the removed section may be a machined portion. The machined portion may include the machined surface formed by the removal of the removed section. In another non-limiting example, machining the portion of the component may also include boring an aperture in the portion of the component. The bored aperture may be formed in the portion of the body of the component including the defect, and more specifically, the bored aperture may be formed directly on or in the defect to substantially cover, encompass, consume, and/or remove the defect from the component. The size and/or geometry of the bored aperture may be known and/or calculated based on the size/geometry, and/or type of defect identified in the component.

The machining processes performed on the portion of the component may be dependent, at least in part, on where on the body of the component the defect is identified, detected, and/or discovered, and/or the type of defect identified in the component. For example, where the component experiences material growth or deformation (e.g., defect) at an end of the body due to material creep, a section of the body of the component including the material deformation may be completely removed to form a machined surface. In another non-limiting example where the component includes a crack or opening formed at least partially through the body, an aperture may be bored through the body over, and substantially covering, consuming and/or removing the crack or opening.

In process P3, material may be deposited on the component. More specifically, material may be direct metal laser deposited directly on the machined portion of the component to form a directionally solidified structure integral with the component. Direct metal laser depositing the material may also include performing a directional solidification process, which may form the directional solidified structure. Performing the directional solidification process may include forming columnar dendrites in the directionally solidified structure formed integral with the component. That is, the directionally solidified structure formed integral with the machined portion of the component may include columnar dendrites as a result of direct metal laser depositing the material and, specifically performing the directional solidification process, in process P3.

Direct metal laser depositing the material on the machined portion of the component may be specific to and/or dependent upon identifying the defect in process P1 and/or the machining process of P2. Specifically, where the material is direct metal laser deposited on the component, and/or the geometry, shape and/or portion of the body of the component formed by the directionally solidified structure may be dependent upon identifying the defect in process P1 and/or the machining process P2. For example, where a section of the body including an end having material deformation (e.g., identified defect) may be removed from the component (e.g., process P2), the material may be direct metal laser deposited directly on the machined surface of the machined portion of the component. In this example, the material may be direct metal laser deposited directly on the machined surface in place of the removed section of the component to form the directionally solidified structure. The directionally solidified structure formed integrally on the machined surface may include a geometry substantially similar to an initial and/or a desired geometry of the removed section including the end of the body. In an example where the component includes a turbine blade or stator nozzle, and the body includes an airfoil, the section removed may include a tip of the airfoil for the turbine blade, or alternative a tip and inner shroud of the stator nozzle, respectively. In another non-limiting example where an aperture may be bored (e.g., process P2) through the body of the component, over, and substantially covering, consuming and/or removing the crack or opening (e.g., identified defect), the material may be direct metal laser deposited directly into the bored aperture in the component. Direct metal laser depositing the material directly into the bored aperture formed in the body of the component may include substantially filling the bored aperture formed in the component with the material to form the directionally solidified structure. That is, the material direct metal laser deposited into the bored aperture formed in the component may substantially fill the bored aperture, such that the directionally solidified structure formed in the bored aperture may include a size and/or geometry that substantially corresponds to and/or is substantially similar to the size and/or geometry of the bored aperture.

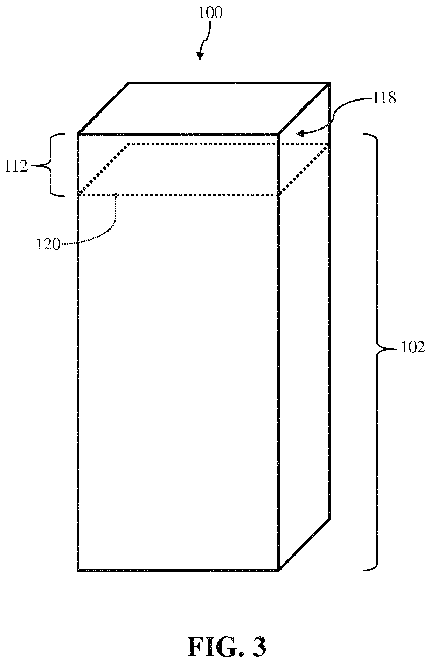

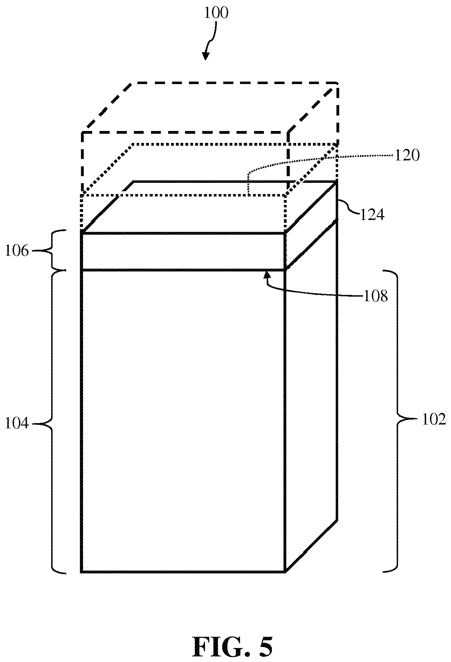

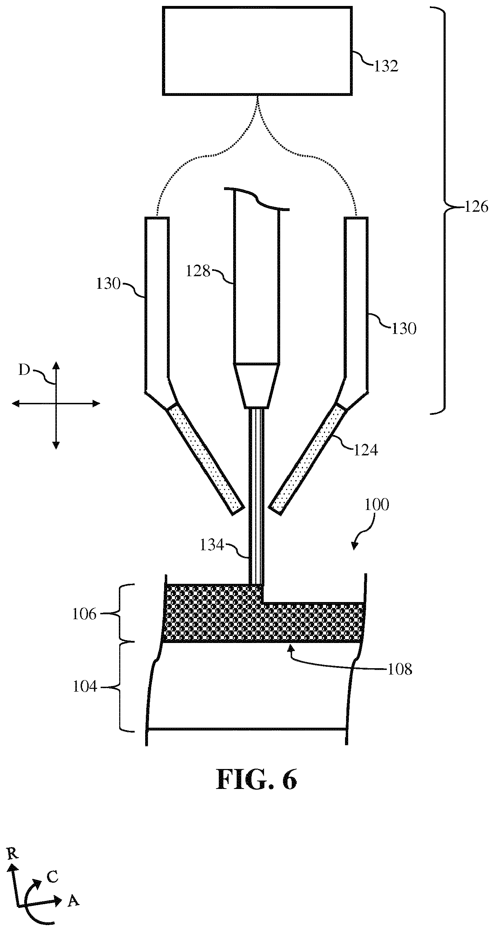

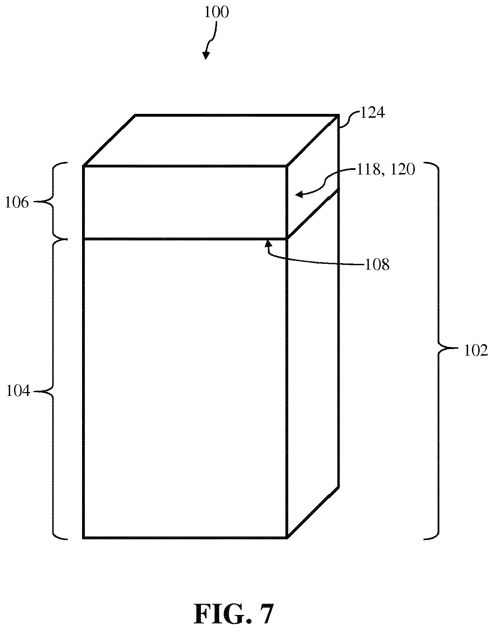

FIGs. 3-5 and 7 depict perspective views of component 100 undergoing a treatment and/or repair process performed, at least partially, by an additive manufacturing system (*see*, FIG. 6), according to embodiments. Specifically, FIG. 3 shows a perspective view of component 100 including an identified defect, FIG. 4 shows a perspective view of component 100 after performing a machining process, FIG. 5 shows a perspective view of machined component 100 including a portion of a material direct metal laser deposited on machined portion 104 to form directionally solidified (DS) structure 106, and FIG. 7 shows a perspective view of machined component 100 including completed directionally solidified (DS) structure 106. FIG. 6 shows an additive manufacturing system configured to direct metal laser deposited material directly on machined portion 104 of component 100, and perform a directional solidification process to form DS structure 106. It is understood that similarly numbered and/or named components may function in a substantially similar fashion. Redundant explanation of these components has been omitted for clarity.

Turning to FIG. 3, illustrative component 100 is shown. Component 100 may be inspected to identify a defect 112. More specifically, component 100 may be inspected, observed, examined, and/or scanned to identify any defect(s) 112, and identify, detect, discover, and/or determine the location of identified defect(s) 112 on and/or in body 102 of component 100. Component 100 may be inspected to identify defect(s) 112, and identify which portion(s) of body 102 include the identified defect(s) 112 using any suitable method, process, and/or system. In a non-limiting example, component 100 may be observed and/or viewed by a user who may visually, and/or through manual measurements, may identify defect(s) 112, and identify which portion(s) of component 100 include the identified defect(s) 112. In another non-limiting example, component 100 may be observed and/or scanned by an observation and/or inspection system, which may automatically identify defect(s) 112, and identify which portion(s) of body 102 of component 100 include the identified defect(s) 112. In an additional non-limiting example, a Dye Penetrant Inspection process may be performed on component 100.

In the non-limiting example shown in FIG. 3, after inspecting component 100, it may be determined that component 100 includes defect 112 formed on and/or in body 102. Specifically, defect 112 may be identified to be formed in, on and/or at an end 118 of component 100. Defect 112 of component 100 may include material deformation, growth, and/or elongation at end 118 of body 102 of component 100. Defect 112 of component 100 which includes the material growth or deformation in body 102 may be a result of material creep after component 100 is used for its intended purpose. For example, the material creep may be a result of component 100 being exposed to high temperature during use or operation. As shown in the non-limiting example of FIG. 3, defect 112 of component 100 caused by material creep may alter the shape, size, and/or geometry of component 100 from its initial and/or desired shape, size, and/or geometry (*see*, FIG. 7). That is, defect 112 of component 100 caused by material creep may extend and/or elongate end 118 of component 100 radially beyond or above the desired and/or initial position or geometry 120 (shown in phantom) of end 118 for component 100. Inspecting component 100 to identify defect 112, as shown in FIG. 3, may be substantially similar to process P1 discussed herein with respect to FIG. 2.

Turning to FIG. 4, a portion of component 100 may be machined. For example, a portion of component 100 including identified defect 112 may be machined. In a non-limiting example, machining component 100 may include removing a portion or section 122 (hereafter, "section 122") of component 100, including identified defect 112, from component 100. In the non-limiting example shown in FIG. 4, section 122 removed from component 100 may include end 118 of component 100, as well as, additional portions of component 100. That is, section 122 removed from component 100 may include defect 112 formed on, in, and/or at end 118, and additional portions of component 100 that may be formed and/or positioned below the desired and/or initial position or geometry 120 of end 118 for component 100. Machining component 100, and more specifically removing section 122 of component 100, may substantially remove and/or eliminate defect 112, and/or the portion of component 100 including defect 112, from body 102 of component 100. Component 100 may be machined, and more specifically section 122 may be removed, using any suitable tool, machine, system, and/or material removal process or technique. For example, section 122 of component 100 may be removed by cutting component 100 using a cutting device.

Machining component 100, and more specifically removing section 122 of component 100, may result in the formation of machined portion 104 of component 100. That is in the non-limiting example shown in FIG. 4, removing section 122 of component 100 including defect 112 may result in the formation of machined portion 104 of component 100. Machined portion 104 of component 100 may include the remaining portion of component 100 formed from the equiaxed material, or preexisting, directionally solidified structure, that is not machined, and more specifically removed with section 122 including defect 112. Additionally, machining component 100, and more specifically removing section 122 of component 100 including defect 112, may form machined surface 108 on machined portion 104 of component 100. Machined surface 108 may be substantially exposed after removing section 122 of component 100. Machining component 100, and more specifically removing section 122 of component 100 including defect 112, as shown in FIG. 4, may be substantially similar to process P2 discussed herein with respect to FIG. 2.

FIG. 5 shows a material 124 being deposited on component 100. More specifically, FIG. 5 shows a portion of material 124 after being direct metal laser deposited on machined portion 104 component 100 to form directionally solidified structure 106 (hereafter, "DS structure 106"). In the non-limiting example, material 124 is direct metal laser deposited directly on, integral with, and/or directly contacts machined surface 108 of machined portion 104. As such, DS structure 106 formed from direct metal laser depositing material 124 may be in direct contact with and/or formed integral with machined surface 108 and/or machined portion 104 of component 100. As discussed herein, direct metal laser depositing material 124 onto machined portion 104 of component 100 to form DS structure 106 may include performing a directional solidification process for material 124. As a result of performing the directional solidification process, DS structure 106 formed from material 124 may include columnar dendrites (*see*, FIG. 1, insert 110). The columnar dendrites of DS structure 106 of component 100 may be structurally, materially, physically and/or characteristically distinct from the equiaxed material formation of machined portion 104 of component 100, as discussed herein. In other non-limiting examples, the columnar dendrites of DS structure 106 may include tree-like grain or crystal growth structures formed or grown along a crystallographic direction that may be substantially similar to, or distinct from, the crystallographic direction of the tree-like grain or crystal growth structures of the preexisting, directionally solidified structure forming machined portion 104, as discussed herein.

Turning to FIG. 6, a portion of component 100 and an illustrative additive manufacturing system 126 are shown. Additive manufacturing system 126 (hereafter, "AMS 126") may be utilized and/or configured to form DS structure 106, as discussed herein. Specifically, AMS 126 may be configured to direct metal laser deposit material 124 directly on machined portion 104 and/or machined surface 108 of machined portion to form DS structure 106. As shown in FIG. 6, AMS 126 may include at least one energy emitting device 128 (one shown), and at least one material dispensing device 130 positioned adjacent to and/or substantially surrounding energy emitting device 128. AMS 126 may also include a material storage component 132 in communication with material dispensing device(s) 130. Material storage component 132 may store material 124 used by AMS 126 and may be configured to provide material 124 to material dispensing device(s) 130 during the direct metal laser depositing process.

During the direct metal laser depositing process to form DS structure 106, energy emitting device(s) 128 of AMS 126 may emit an energy beam 134 toward machined surface 108 and/or machined portion 104 of component 100. Simultaneously, material dispensing device(s) 130 may also dispense material 124 toward machined surface 108 and/or machined portion 104 of component 100. More specifically, material dispensing device(s) 130 may dispense material 124 toward machined surface 108 and/or machined portion 104 of component 100, and may dispense material 124 into the path of energy beam 134 of energy emitting device(s) 128 of AMS 126. Material 124 dispensed by material dispensing device(s) 130 may enter the path and/or interact with energy beam 134 of energy emitting device(s) 128 above machined portion 104, and/or the most recent layer of DS structure 106. When material 124 interacts with energy beam 134, material 124 may undergo a material transformation process, and may be deposited onto machined portion 104, and/or the previously formed portion of DS structure 106 to form additional or new portions of DS structure 106. In a non-limiting example, when material 124 interacts with energy beam 134 during the direct metal laser deposition, material 124 may undergo a directional solidification process when forming DS structure 106, which results in the formation of columnar dendrites in DS structure 106, as discussed herein. Energy emitting device(s) 128 and material dispensing device(s) 130 may be configured to move in various directions (D) to direct metal laser deposit material 124 to form DS structure 106, as discussed herein. Energy emitting device(s) 128 of AMS 126 may be any suitable device or system that may configured to emit an energy for forming DS structure 106 from material 124. In a non-limiting example, energy emitting device(s) 128 of AMS 126 may include a laser device or system that may be configured to emit a laser beam.

Material 124 may be direct metal laser deposited onto machined portion 104 of component 100 until DS structure 106 forms a desired structure or portion of component 100, as shown in FIG. 7. As shown in FIG. 7, material 124 is direct metal laser deposited onto machined portion 104 to form DS structure 106 until DS structure 106 includes a desired structure, shape, size and/or geometry to repair component 100. In the non-limiting example shown in FIG. 7, and continuing the example discussed herein with reference to FIGs. 3 and 4, material 124 is DMLD onto machined portion 104 in order for DS structure 106 to repair component 100 by replacing section 122 previously removed from component 100 (*see*, FIG. 4). Specifically, DS structure 106 is formed to repair component 100 by replacing removed section 122 which included end 118 and/or defect 112 formed in end 118 of component 100 (*see*, FIGs. 3 and 4). As shown in FIG. 7, DS structure 106 may also be formed on machined portion 104 such that DS structure 106 is substantially the same or identical to the desired and/or initial position or geometry 120 of end 118 for component 100 (*see also*, FIG. 4). As a result, DS structure 106 may repair component 100 by (re)forming end 118 of component 100. direct metal laser depositing material 124 on machined portion 104 of component 100 to form DS structure 106, as shown in FIGs. 5-7, may be substantially similar to process P3 discussed herein with respect to FIG. 2.

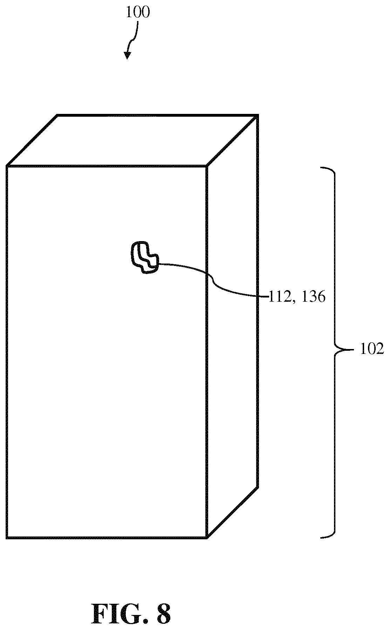

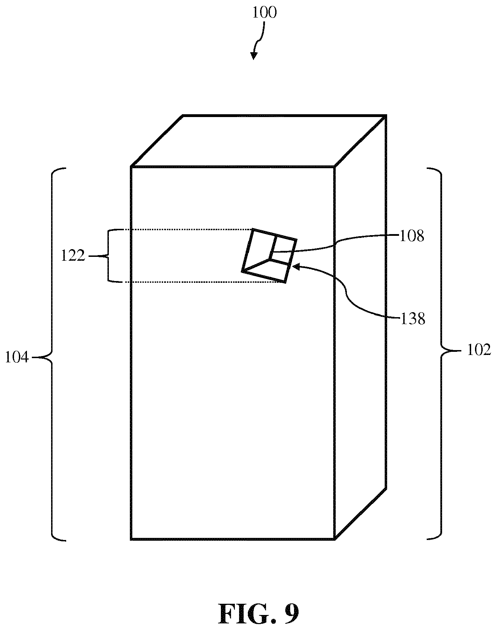

FIGs. 8-10 depict perspective views of illustrative component 100 undergoing another non-limiting example of a repair process performed, at least partially, by AMS 1126 (*see*, FIG. 6), according to embodiments. Specifically, FIG. 8 shows a perspective view of component 100 including an identified defect 112, FIG. 9 shows a perspective view of component 100 after performing a machining process, and FIG. 10 shows a perspective view of machined component 100 including directionally solidified (DS) structure 106 formed by direct metal laser depositing. It is understood that similarly numbered and/or named components may function in a substantially similar fashion. Redundant explanation of these components has been omitted for clarity.

In the non-limiting example shown in FIG. 8, and similar to FIG. 3, component 100 may undergo an inspection process to determine that component 100 includes defect 112 on and/or in component 100. However, and distinct from the non-limiting example discussed herein with respect to FIG. 3, defect 112 in the non-limiting example shown in FIG. 8 may be located or formed in a distinct portion of component 100 and/or may be a distinct defect-type. Defect 112 may be identified to be formed in, on and/or partially through component 100. Specifically in the non-limiting example, defect 112 may be formed in, on, and/or partially through body 102 of component 100. As shown in FIG. 8, defect 112 of component 100 may include a crack or opening 136 (hereafter, "opening 136"). Defect 112 of component 100 which includes opening 136 formed at least partially through component 100 may be a result of undesirable stress and/or undesirable contact with debris during use of component 100. Defect 112 formed as opening 136 may reduce the operational efficiencies and/or function of component 100, and/or may increase the risk of subsequent damage to component 100 during use.

Turning to FIG. 9, a portion of component 100 may be machined. For example, a portion of component 100 including identified defect 112 may be machined. Specifically, machining component 100 may include removing section 122 including identified defect 112 from body 102 and/or component 100. Additionally, Machining component 100 may also include boring opening 136 in component 100 to form a bored recess or aperture 138 (hereafter, "bored aperture 138"). That is, defect 112 formed as opening 136 may be bored to form bored aperture 138 in component 100 to substantially cover, consume, encompass and/or remove opening 136 (e.g., "defect 112"). The size and/or geometry of bored aperture 138 may be known and/or calculated based on the size/geometry, and/or type of defect 112 and/or opening 136 identified in component 100. For example, and as discussed herein, size and/or geometry of bored aperture 138 may be known and substantially larger than opening 136 to substantially cover, consume, encompass and/or remove opening 136 from component 100. Knowing the size and/or geometry of bored aperture 138 may ensure that the AMS 126 (*see*, FIG. 6) utilized to repair component 100 may direct metal laser deposit material 124 into bored aperture 138, to form DS structure 106 (*see*, FIG. 10) to substantially fill bored aperture 138.

In the non-limiting example shown in FIG. 9, section 122 removed from component 100 may include a portion of component 100, and more specifically a portion of body 102 of component 100. As such, bored aperture 138 may be formed by boring a portion of body 102 of component 100 to form section 122. Boring component 100 to form bored aperture 138 may substantially remove and/or eliminate defect 112/opening 136, and/or the portion of component 100 including defect 112, from component 100. Component 100 in the non-limiting example may be bored to form bored aperture 138 using any suitable tool, machine, system, and/or material removal process or technique. For example, bored aperture 138 of component 100 may be formed by boring, grinding and/or milling component 100 using a milling or rotatable-cutting device.

Similar to the non-limiting example discussed herein with respect to FIG. 4, machining component 100 may result in the formation of machined portion 104 of component 100. That is in the non-limiting example shown in FIG. 9, boring opening 136 (e.g., defect 112) on component 100 to form bored aperture 138 may result in the formation of machined portion 104 of component 100. Machined portion 104 of component 100 may include the remaining portion of component 100 formed from the equiaxed material, or the preexisting directionally solidified structure, that is not machined, removed with section 122, and/or removed when forming bored aperture 138. Additionally, boring component 100 to form bored aperture 138 may form machined surface 108 on machined portion 104 of component 100, and/or substantially within bored aperture 138. Machined surface 108 may be substantially exposed after machining component 100 to form bored aperture in component 100.

FIG. 10 shows material 124 direct metal laser deposited onto machined portion 104 and/or machined surface 108 (*see*, FIG. 9) of component 100 to form DS structure 106 until DS structure 106 includes a desired structure, shape, size and/or geometry to repair component 100. Continuing the non-limiting example discussed herein with respect to FIGs. 8 and 9, material 124 may be direct metal laser deposited directly into bored aperture 138 (*see*, FIG. 9) to form DS structure 106 on machined portion 104. Material 124 is direct metal laser deposited onto machined portion 104 to repair component 100 by replacing section 122 (*see*, FIG. 9) previously removed from component 100, and/or substantially filling bored aperture 138. As shown in FIG. 10, DS structure 106 may also be formed on or in machined portion 104 such that DS structure 106 includes a shape and/or geometry that is substantially the same, identical, and/or corresponds to the known shape and/or geometry of bored aperture 138 formed in component 100. As similarly discussed herein with respect to process P3 (*see*, FIG. 2) and the non-limiting example of FIGs. 5-7, DS structure 106 may be formed by direct metal laser depositing material 124 on and/or in machined portion 104 of component 100, such that material 124 and/or DS structure 106 may be in direct contact with and/or formed integral with machined portion 104 of component 100. That is, energy emitting device(s) 128 and material dispensing device(s) 130 of AMS 126 (*see*, FIG. 6) may be positioned substantially within and/or above bored aperture 138 and may form DS structure 106 therein by direct laser metal depositing material 124 into bored aperture 138. Additionally as discussed herein, DS structure 106 formed by direct metal laser depositing material 124 onto machined portion 104 of component 100 may include performing a directional solidification process, which may result in the formation of columnar dendrites (*see*, FIG. 1, insert 110) in DS structure 106. DS structure 106 formed in and/or filling bored aperture 138 may repair component 100 by (re)forming and/or completing component 100.

Although discussed herein as two distinct, non-limiting examples, it is understood that component 100 may include a plurality of defects 112 that may be substantially similar to both defect 112 (e.g., end 118) discussed herein with respect to FIGs. 3-7, and defect 112 (e.g., opening 136) discussed herein with respect to FIGs. 8-10. In the non-limiting example (not shown) where component 100 includes a plurality of defects 112, the process of repairing component 100, as discussed herein with respect to FIG. 2, may be performed various times to repair each defect 112 of component 100.

Component 100 may be formed as various other components formed substantially from equiaxed material, or the preexisting directionally solidified structure, that may be utilized for various purposes/operations, and may be included within various devices and/or systems. In non-limiting examples, component 100 may include turbine blades (*see*, FIG. 11), and/or stator vanes (*see*, FIG. 12) that may be utilized within various turbomachines (e.g., gas turbine system, steam turbine system, combined power plants and so on). It is understood that similarly numbered and/or named components may function in a substantially similar fashion. Redundant explanation of these components has been omitted for clarity.

In the non-limiting example shown in FIG. 11, component 100 may include a turbine blade 140. Turbine blade 140 shown in FIG. 11 may be any turbine blade included in a plurality of turbine blades utilized in various portions (e.g., compressor, turbine) in a turbomachine (not shown). Turbine blade 140 of FIG. 11 may be shown or depicted after having undergone repair process(es), as discussed herein. That is, in a non-limiting example, turbine blade 140 depicted in FIG. 11 may be a "treated" or "repaired" turbine blade 140 that may have been previously used within turbomachines. However, in another non-limiting example, turbine blade 140 shown in FIG. 11 may be formed, created, built and/or manufactured to include the features discussed herein.

Turbine blade 140 may include body 102 or airfoil 142 (hereafter, "airfoil 142"). Airfoil 142 of turbine blade 140 may be positioned and/or extend radially from a platform 144, and may be positioned radially above a shank 146 positioned and/or extend radially below platform 144. Platform 144 and shank 146 of turbine blade 140 may be formed from any suitable material that may withstand the operational characteristics and/or attributes (e.g., combustion gases pressure, internal temperature, and so on) of a turbomachine. Additionally, platform 144 and/or shank 146 may be formed using any suitable formation and/or manufacturing technique and/or process.

Distinct from platform 144 and/or shank 146, and as discussed herein, airfoil 142 of turbine blade 140 may be formed to include various portions, structures, and/or sections that may be formed from various materials that may be unique when compared to materials forming other portions, structures, and/or sections of turbine blade 140. In the non-limiting example shown in FIG. 11, airfoil 142 of turbine blade 140 may include and/or be formed from at least one machined portion 104a, 104b and at least one directionally solidified (DS) structure 106a, 106b. In one non-limiting example including machined portion 104a, and similar to the non-limiting example discussed herein with respect to FIGs. 3-7, machined portion 104a may include a portion of airfoil 142 of turbine blade 140 extending radially from platform 144. Additionally, machined portion 104a of turbine blade 140 may also include a machined surface 108a. Machined surface 108a may be formed in machined portion 104 when forming and/or repairing airfoil 142 of turbine blade 140. Specifically, and as similarly discussed herein with respect to component 100 in FIGs. 2-7, machined surface 108a of machined portion 104a may be formed when a portion or section of turbine blade 140 is machined, and more specifically removed, from airfoil 142 of turbine blade 140 (*see*, FIG. 4). Machined portion 104a of turbine blade 140 may be formed from equiaxed material that may include (equiaxed) grains or crystals that include substantially similar or identical sizes, geometries and/or axes lengths, as discussed herein. In other non-limiting examples, machined portion 104a of turbine blade 140 may be formed from the preexisting directionally solidified structure, as discussed herein.

Continuing the non-limiting example shown in FIG. 11, DS structure 106a may be formed directly on and/or as a portion of airfoil 142 of turbine blade 140. More specifically, DS structure 106a may be formed directly on and/or integral with machined portion 104a of airfoil 142 of turbine blade 140. Additionally, DS structure 106a may be formed directly on machined surface 108a of machined portion 104a, such that machined surface 108a of machined portion 104a may be in direct contact with DS structure 106a. In the non-limiting example shown in FIG. 11, DS structure 106a may be formed directly on and/or integral with machined portion 104a to substantially form tip 148 of airfoil 142 of turbine blade 140. As discussed herein with respect to component 100 in FIGs. 2-7, DS structure 106a may include a geometry substantially similar to an initial and/or desired geometry 120 (*see*, FIG. 3) of the section of airfoil 142 removed from turbine blade 140 to form machined surface 108a and/or machined portion 104a.

Also similar to the formation of DS structure 106 for component 100 (*see*, FIGs. 2-7), DS structure 106a may be formed on and/or integral with machined portion 104a of turbine blade 140 by direct metal laser depositing a nickel-based superalloy material directly on machined surface 108a and/or machined portion 104a. By direct metal laser depositing the nickel-based superalloy material directly on machined portion 104a, the superalloy material forming DS structure 106 may undergo a directional solidification process, which may result in DS structure 106a including directional or columnar dendrites (*see*, FIG. 1, magnified insert 110), or tree-like grain or crystal growth structures that are formed as a result of the grain or crystals growing along favorable crystallographic directions within the material during the directional solidification process.

In another non-limiting example shown in FIG. 11 including machined portion 104b, and similar to the non-limiting example discussed herein with respect to FIGs. 8-10, DS structure 106b may be formed on, and/or integral with machined portion 104b of airfoil 142. That is, machined portion 104b may previously include defect 112 which includes opening 136, as similarly discussed herein with respect to FIG. 8. As such, airfoil 142 of turbine blade 140 may be machined, and more specifically may be bored to form bored aperture 138 to remove defect 112/opening 136 from airfoil 142. As discussed herein, material 124 may subsequently be direct metal laser deposited directly into and/or may fill bored aperture 138 to form DS structure 106b on or in machined portion 104b of airfoil 142 of turbine blade 140. As similarly discussed herein, material 124 is direct metal laser deposited onto machined portion 104b to repair turbine blade 140 by substantially filling bored aperture 138. As shown in FIG. 11, DS structure 106b may also be formed on or in machined portion 104b such that DS structure 106b includes a shape and/or geometry that is substantially the same, identical, and/or corresponds to the known shape and/or geometry of bored aperture 138 formed in airfoil 142 of turbine blade 140.

The machining process to form the various machined portions 104a, 104b and the direct metal laser depositing of material 124 to form the various DS structure 106a, 106b shown in the non-limiting example of FIG. 11 may be substantially similar to those processes discussed herein with respect to FIGs. 2-10. Additionally because of the similar processes, DS structure 106a, 106b formed in and/or on machined portion 104a, 104b of turbine blade 140 may include columnar dendrites (*see*, FIG. 1, magnified insert 110) to improve operational characteristics (e.g., reduce creep, reduce oxidation) for turbine blade 140. Redundant explanation of these processes has been omitted for clarity.

In the non-limiting example shown in FIG. 12, component 100 may include a stator vane 150. Similar to turbine blade 140 of FIG. 11, stator vane 150 shown in FIG. 12 may be any stator vane included in a plurality of stator vanes utilized in various portions (e.g., compressor, turbine) in a turbomachine (not shown). Stator vane 150 of FIG. 12 may be shown or depicted after having undergone repair process(es), as discussed herein. That is, in a non-limiting example, stator vane 150 may be a "treated" or "repaired" stator vane that may have been previously used within turbomachines. However, in another non-limiting example, stator vane 150 shown in FIG. 12 may be formed, created, built and/or manufactured to include the features discussed herein.

Stator vane 150 may include body 102 or airfoil 152 (hereafter, "airfoil 152"). Airfoil 152 of stator vane 150 may be positioned and/or extend radially between an inner shroud 154 and an outer shroud 156 coupled to a housing or casing of a housing or component of a turbomachine. As such, outer shroud 156 may be positioned radially above inner shroud 154 and airfoil 152, respectively, and/or may be positioned opposite inner shroud 154.

Airfoil 152, inner shroud 154, and/or outer shroud 156 of stator vane 150 may be formed to include various portions, structures, and/or sections that may be formed from various materials that may be unique when compared to materials forming other portions, structures, and/or sections of stator vane 150. In the non-limiting example shown in FIG. 12, and similar to turbine blade 140 discussed herein with respect to FIG. 11, stator vane 150 may include and/or be formed from at least one machined portion 104a, 104b and at least one directionally solidified (DS) structure 106a, 106b. In a non-limiting example, and similar to the non-limiting example discussed herein with respect to FIGs. 3-7, machined portion 104a may a portion of airfoil 152 of stator vane 150 extending radially from outer shroud 156. Additionally, machined portion 104a of airfoil 152 may also include a machined surface 108a. Machined surface 108 may be formed in machined portion 104a when forming and/or repairing airfoil 152 of stator vane 150. Specifically, and as similarly discussed herein with respect to FIGs. 3-7, machined surface 108a of machined portion 104a may be formed when a portion or section of airfoil 152 is machined, and more specifically removed, from stator vane 150 (*see*, FIG. 4). Also in the non-limiting example, machined portion 104a and/or machined surface 108a may be formed after performing a machining process (e.g., process P2) on stator vane 150 to remove a portion or section of airfoil 152, tip 158 of airfoil 152 of stator vane 150, and inner shroud 154, along with a portion or section of airfoil 152, and tip 158 of airfoil 152. In a non-limiting example, the portion or section of airfoil 152, tip 158 and inner shroud 154 may be removed to form machined portion 104a after identifying a defect 112 within at least one of the portion or section of airfoil 152, tip 158 and inner shroud 154, as discussed herein. Machined portion 104a of stator vane 150 may be formed from equiaxed material that may include (equiaxed) grains or crystals that include substantially similar or identical sizes, geometries and/or axes lengths, as discussed herein. In other non-limiting examples, machined portion 104a of stator vane 150 may be formed from the preexisting directionally solidified structure, as discussed herein.

As shown in FIG. 12, DS structure 106a may be formed directly on and/or as a portion of airfoil 152. More specifically, DS structure 106a may be formed directly on and/or integral with machined portion 104a of airfoil 152 of stator vane 150. Additionally, DS structure 106a may be formed directly on machined surface 108a of machined portion 104a, such that machined surface 108a of machined portion 104a may be in direct contact with DS structure 106a. In the non-limiting example shown in FIG. 12, and as similarly discussed herein with respect to FIGs. 3-7, DS structure 106a may be formed directly on and/or integral with machined portion 104a to substantially form a portion or section of airfoil 152 and tip 158 of airfoil 152 of stator vane 150. Additionally in the non-limiting example shown in FIG. 12, DS structure 106a may also include inner shroud 154 of stator vane 150 formed integrally with a portion or section of airfoil 152 and tip 158 of airfoil 152.

Also similar to the formation of DS structure 106 for component 100 (*see*, FIGs. 2-7), DS structure 106a may be formed on and/or integral with machined portion 104a of stator vane 150 by direct metal laser depositing a nickel-based superalloy material directly on machined surface 108a and/or machined portion 104a. By direct metal laser depositing the nickel-based superalloy material directly on machined portion 104a, the superalloy material forming DS structure 106a may undergo a directional solidification process, which may result in DS structure 106a including directional or columnar dendrites (*see*, FIG. 1, magnified insert 110), or tree-like grain or crystal growth structures that are formed as a result of the grain or crystals growing along favorable crystallographic directions within the material during the directional solidification process.

In another non-limiting example shown in FIG. 12, stator vane 150 may include machined portion 104b that may include substantially all of airfoil 152 of stator vane 150. Machined portion 104b of airfoil 152 may be formed as a result of identifying defect 112 (e.g., opening 136) within airfoil 152, and subsequently machining airfoil 152. Specifically, machined portion 104b may be formed after boring airfoil 152 and forming bored aperture 138 to substantially remove defect 112/opening 136 formed in airfoil 152 of stator vane 150, as discussed herein.

In the non-limiting example including machined portion 104b, and similar to the non-limiting example discussed herein with respect to FIGs. 8-10, DS structure 106b may be formed on, and/or integral with machined portion 104b of airfoil 152. That is, material 124 may be direct metal laser deposited directly into and/or may fill bored aperture 138 to form DS structure 106b on or in machined portion 104b of airfoil 152 for stator vane 150. As similarly discussed herein, material 124 is direct metal laser deposited onto machined portion 104b to repair stator vane 150 by substantially filling bored aperture 138. As shown in FIG. 12, DS structure 106b may also be formed on or in machined portion 104b such that DS structure 106b includes a shape and/or geometry that is substantially the same, identical, and/or corresponds to the known shape and/or geometry of bored aperture 138 formed in airfoil 152 of stator vane 150.

The machining process to form the various machined portions 104a, 104b and the direct metal laser depositing of material 124 to form the various DS structure 106a, 106b shown in the non-limiting example of FIG. 12 may be substantially similar to those processes discussed herein with respect to FIGs. 2-10. Additionally because of the similar processes, DS structure 106a, 106b may include columnar dendrites (*see*, FIG. 1, magnified insert 110) to improve operational characteristics (e.g., reduce creep, reduce oxidation) for stator vane 150. Redundant explanation of these processes has been omitted for clarity.

The technical effect is to provide a treatment process for components formed from equiaxed material, or preexisting directionally solidified structures, that may improve physical and/or material characteristics of the component by treating the component with directionally solidified structures.

The foregoing drawings show some of the processing associated according to several embodiments of this disclosure. In this regard, each drawing or block within a flow diagram of the drawings represents a process associated with embodiments of the method described. It should also be noted that in some alternative implementations, the acts noted in the drawings or blocks may occur out of the order noted in the figure or, for example, may in fact be executed substantially concurrently or in the reverse order, depending upon the act involved. Also, one of ordinary skill in the art will recognize that additional blocks that describe the processing may be added.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about," "approximately" and "substantially," are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/- 10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description, but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

## Claims

1. A method of treating a component, the method comprising:
machining a portion of the component, the component formed from one of an equiaxed material or a preexisting directionally solidified structure; and
direct metal laser depositing (DMLD) a material on the machined portion of the component to form a deposited, directionally solidified structure integral with the component.

2. The method as claimed in claim 1, wherein machining the portion of the component includes at least one of:
removing a section of the component to form a machined surface, or
boring an aperture in the component.

3. The method as claimed in claim 2, wherein DMLD the material includes:
DMLD the material directly on the machined surface in place of the removed section of the component to form the deposited, directionally solidified structure, the deposited, directionally solidified structure including a geometry substantially similar to an initial geometry of the removed section.

4. The method as claimed in claim 2, wherein DMLD the material includes:
DMLD the material directly in the bored aperture in the component.

5. The method as claimed in claim 4, further comprising:
filling the bored aperture in the component with the deposited material.

6. The method as claimed in any preceding claim, further comprising:
identifying a defect in the portion of the component prior to machining the portion of the component.

7. The method as claimed in any preceding claim, wherein the material includes nickel-based superalloys.

8. The method as claimed in any preceding claim, wherein the component includes:
a turbine blade including an airfoil, or a stator vane including an airfoil.

9. The method as claimed in any preceding claim, wherein DMLD the material includes:
forming columnar dendrites in the deposited, directionally solidified structure integral with the machined portion of the component.

10. A component, comprising:
a body including:
a machined portion, the machined portion of the body formed substantially from one of an equiaxed material or a preexisting directionally solidified structure; and
a deposited, directionally solidified structure formed directly on the machined portion of the body, the deposited, directionally solidified structure laser deposited on the machined portion of the body.

11. The component as claimed in claim 10, the deposited, directionally solidified structure is formed from a material including nickel-based superalloys.

12. The component as claimed in claim 10, wherein the deposited, directionally solidified structure formed directly on the machined portion of the body includes columnar dendrites.

13. The component as claimed in claim 10, wherein the machined portion of the body includes a machined surface, the machined surface in direct contact with the deposited, directionally solidified structure.

14. The component as claimed in claim 10, wherein the machined portion of the body includes a bored aperture, the bored aperture substantially filled with the deposited, directional solidified structure.

15. The component as claimed in claim 10, wherein:
the body includes an airfoil of a turbine blade, and
the deposited, directionally solidified structure forms a tip of the airfoil of the turbine blade.
